# FASCICULE DE BREVET EUROPEEN

(11) **EP 1 936 659 B1**
(45) Date de publication et mention de la délivrance du brevet: **09.04.2014**
(21) Numéro de dépôt: 08103311.0
(22) Date de dépôt: 08.10.2007
(51) Int. Cl.: H01J 37/32, C23C 16/04, C23C 16/511, B05D 7/02, B05D 7/22, B05D 1/00

(54) **Installation de dépôt, au moyen d'un plasma micro-ondes, d'un revêtement barrière interne dans des récipients thermoplastiques**
Anlage zur Abscheidung einer inneren Sperrschicht in thermoplastischen Behältern mit Hilfe eines Mikrowellenplasmas
Installation for depositing, by means of microwave plasma, an internal barrier coating in thermoplastic containers

(30) Priorité: 13.10.2006 FR 0609020
(43) Date de publication de la demande: 25.06.2008
(62) Demande divisionnaire de: 07118033.5
(73) Titulaire: Sidel Participations, 76930 Octeville Sur Mer (FR)
(72) Inventeur: Duclos, Yves Alban Sidel Participations, 76930, OCTEVILLE-SUR-MER (FR)
(74) Mandataire: Cabinet Plasseraud

(56) Documents cités:
- WO-A-03/100124
- FR-A1- 2 799 994
- FR-A1- 2 872 148

## Description

La présente invention concerne d'une façon générale le domaine de la fabrication de récipients thermoplastiques, notamment en PET, dont la paroi est pourvue d'une couche interne d'un revêtement barrière, par exemple en carbone, silice ou autre, propre à empêcher ou freiner les échanges moléculaires ou ioniques à travers la paroi.

L'invention concerne plus spécifiquement des perfectionnements apportés aux installations de dépôt, au moyen d'un plasma micro-ondes, d'un revêtement formant barrière sur la face interne de récipients en matière thermoplastique tel que du PET, cette installation comprenant une multiplicité de postes de traitement individuel de récipients qui comportent chacun une enceinte de traitement et un bloc supérieur formant un couvercle incluant une chambre de pompage à vide avec laquelle sont en communication des organes fonctionnels de ladite installation susceptibles d'être recouverts au moins partiellement de matériau pulvérulent constitutif du susdit revêtement lors du fonctionnement de l'installation.

Le mode de fonctionnement et un exemple de structure d'un poste de traitement pour une installation du type considéré sont décrits et illustrés notamment dans le document FR 2 776 540 au nom de la Demanderesse.

Pendant le traitement du récipient, un champ de micro-ondes est émis à l'intérieur de l'enceinte de traitement et ce champ se développe vers la chambre de pompage à travers une chemise. Les micro-ondes qui se propagent à l'intérieur de la chemise et à l'intérieur de la chambre de pompage y provoquent des dépôts de particules de matériau barrière (carbone, silice ou autre), ce qui pollue les parois internes de la chemise et de la chambre de pompage, voire même, au-delà, les parois internes du circuit de pompage du fait de l'entraînement de particules non fixées.

Il en résulte une pollution de certains organes fonctionnels de l'installation qui sont au moins en partie couverts de matériau barrière pulvérulent. Il peut en être ainsi par exemple pour des capteurs de pression servant à contrôler les niveaux de vide dans l'enceinte et dans le récipient, capteurs dont le fonctionnement est perturbé, voire qui sont rendus inopérants, lorsque leur surface sensible est opacifiée par un dépôt de matériau pulvérulent.

Toutefois, l'inconvénient majeur de cet entraînement de matériau pulvérulent réside dans le fait qu'une partie se dépose sur certains éléments particulièrement sensibles tels que des joints d'étanchéité équipant certains organes, notamment les joints des électrovannes de commande fluidique (commande sélective d'établissement du vide et de remise à la pression atmosphérique dans l'enceinte et dans le récipient à traiter) qui sont associées au fonctionnement du poste de traitement et situées en aval des moyens de filtrage de la chambre de pompage à vide. Le dépôt de matériau pulvérulent sur ces joints diminue l'élasticité de ceux-ci et réduit leur capacité de déformation à l'écrasement ; il en résulte une diminution de la qualité de l'étanchéité procurée par ces joints, avec comme conséquence directe une réduction du niveau de vide susceptible d'être développé dans l'enceinte et donc des conditions dégradées pour le développement du plasma conduisant au dépôt, sur le récipient, d'un revêtement de matériau barrière de moindre qualité. Il s'agit là d'un défaut fondamental dans le fonctionnement de l'installation et, pour y remédier, il s'avère nécessaire de nettoyer les joints régulièrement et aussi de les remplacer plus souvent qu'il ne serait normalement utile.

Or, dans les installations actuelles, les électrovannes sont montées individuellement en des emplacements divers, en fonction de la place disponible.

De ce fait, la maintenance à assurer sur les joints des électrovannes nécessite le démontage, puis le remontage réguliers de toutes les électrovannes de l'installation, à raison typiquement de 3 électrovannes par poste de traitement (à savoir une électrovanne de mise sous vide du volume intérieur du récipient, une électrovanne de mise sous vide du volume de l'enceinte à l'extérieur du récipient, une électrovanne de remise à la pression atmosphérique qui est commune au volume intérieur du récipient et au volume de l'enceinte à l'extérieur du récipient) ; dans les machines actuelles équipées d'environ 20 postes de traitement, cela représente environ 60 électrovannes. Il s'agit d'un travail considérable qui nécessite une main d'oeuvre qualifiée employée pendant des durées longues et qui implique bien entendu que l'installation soit immobilisée pendant toute la durée de cette opération de maintenance. Il s'agit d'une contrainte que les exploitants acceptent d'autant plus difficilement que la tendance est aujourd'hui de chercher à toujours accroître les cadences de production, ce qui implique au premier chef de restreindre au minimum les temps d'immobilisation des installations en particulier pour la maintenance.

De plus, la recherche de cadences de production toujours plus élevées passe par un accroissement du nombre des postes au sein de chaque installation en raison notamment de l'impossibilité de réduire en dessous d'un certain seuil la durée du processus de dépôt du revêtement de matériau barrière. Ainsi par exemple, la Demanderesse envisage actuellement la production d'installations de plus grande capacité comportant un nombre de postes de traitement porté à environ 48, ce qui représente 192 joints à entretenir régulièrement pour les seules électrovannes. Il n'est alors plus envisageable d'immobiliser l'installation pendant le temps très long exigé pour une maintenance des joints selon les pratiques actuelles.

L'invention a pour but d'apporter une solution visant à donner satisfaction, au moins dans une large limite, aux sollicitations de la pratique et, sans chercher à traiter le problème des dépôts et entraînements de produit pulvérulent au cours du fonctionnement des installations, de proposer un agencement structurel perfectionné desdites installations qui permette de simplifier et accélérer le processus de remise en état des installations et de réduire considérablement les temps d'immobilisation des installations.

A ces fins, l'invention propose une installation selon la revendication 1.

Ces dispositions de l'invention trouvent une application tout particulièrement intéressante dans le cas où les susdits organes fonctionnels sont des électrovannes de commande sélective d'établissement du vide et de remise à la pression atmosphérique dans l'enceinte et dans le récipient à traiter, car les performances de l'installation et la qualité du dépôt de la couche de revêtement barrière sont tout particulièrement dépendantes du niveau de vide maintenu dans le récipient et dans l'enceinte pour la formation du plasma, ce niveau de vide lui-même étant tributaire au premier degré de la qualité de l'étanchéité conférée par les joints des électrovannes commandant le cycle de fonctionnement. Mais, bien entendu, d'autres organes fonctionnels tels que des capteurs de vide ou des débitmètres peuvent aussi être incorporés dans le bloc amovible.

Dans un exemple concret de réalisation, on peut prévoir que les logements des électrovannes de commande du vide à l'intérieur du récipient soient disposés dans des portions du bloc amovible en saillie sur la face d'accouplement et que la face d'accouplement du couvercle comporte des évidements, de formes complémentaires, propres à recevoir lesdites portions en saillie, un tel agencement permettant de simplifier la localisation des entrées et sorties associées auxdites électrovannes. On peut également prévoir que ladite face d'accouplement du bloc amovible soit en saillie par rapport à une face d'assemblage supportant des moyens de liaison mécanique avec le couvercle et que le couvercle comporte un évidement propre à recevoir ladite face d'accouplement en saillie, ce qui facilite le guidage du bloc amovible lors de son montage sur le couvercle respectif et facilite la mise en place d'une étanchéité entre les faces coopérantes du bloc amovible et du couvercle.

Conformément à l'invention, les postes de traitement de l'installation sont répartis en groupes comprenant plusieurs postes adjacents, un bloc amovible commun regroupant les organes fonctionnels desdits plusieurs postes adjacents d'un groupe de postes, et ledit bloc amovible étant fixable sur lesdites faces d'accouplement desdits blocs supérieurs des postes respectifs. Dans ce contexte, il est particulièrement avantageux que les enceintes des postes de traitement adjacents d'un groupe de postes soient rapprochées l'une de l'autre et juxtaposées et que les couvercles respectifs soient eux aussi juxtaposés : un tel agencement conduit à un moindre encombrement dans l'implantation des postes de traitement et un nombre accru de postes de traitement peut être mis en place dans un espace donné. Il devient alors possible de simplifier encore la structure en prévoyant que les postes de traitement d'un groupe de postes soient munis d'un couvercle unique commun et ledit bloc amovible est fixable sur la face d'accouplement du couvercle commun: un tel agencement permet d'accroître considérablement les temps de démontage et de remontage des couvercles du fait qu'en une seule manipulation plusieurs postes de traitement sont traités simultanément ; on réduit ainsi de façon très sensible la durée d'immobilisation de l'installation.

Dans les installations fabriquées par la Demanderesse, à chaque poste de travail sont fonctionnellement associées :
- une électrovanne de commande de mise sous vide du volume intérieur de l'enceinte à l'extérieur du récipient à traiter,
- une électrovanne de commande de mise sous vide du volume intérieur du récipient à traiter,
- une électrovanne de commande de remise à la pression atmosphérique du volume intérieur de l'enceinte à l'extérieur du récipient à traiter, et
- une électrovanne de commande de remise à la pression atmosphérique du volume intérieur du récipient à traiter.

La mise en oeuvre des dispositions conformes à l'invention qui viennent d'être exposées autorise d'agencer l'installation de manière qu'elle comprenne une électrovanne de commande de mise sous vide du volume intérieur du récipient à traiter et une électrovanne de commande de remise à la pression atmosphérique du volume intérieur du récipient à traiter pour chaque poste de traitement et qu'elle comprenne une seule électrovanne de commande de mise sous vide du volume intérieur de l'enceinte à l'extérieur du récipient à traiter et une seule électrovanne de commande de remise à la pression atmosphérique du volume intérieur de l'enceinte à l'extérieur du récipient à traiter qui sont communes à tous les postes de traitement d'un groupe de postes de traitement. Il en résulte une simplification structurelle sensible des postes de traitement et une économie non négligeable en matériels.

Les dispositions conformes à l'invention peuvent trouver application dans des installations de conceptions diverses. Elles peuvent notamment trouver une application avantageuse dans les installations dans lesquelles, pour chaque poste de traitement, le couvercle est fixe et solidaire de l'enceinte respective et le fond de l'enceinte est déplaçable axialement pour autoriser l'introduction et l'évacuation des récipients, disposés col en haut, par le fond de l'enceinte.

Les dispositions conformes à l'invention sont tout particulièrement appropriées pour les installations à hautes performances à cadence élevées, équipées d'un nombre élevé de postes de traitement, telles que celles du type carrousel tournant et comportant un bâti rotatif supportant ladite multiplicité de postes de traitement répartis périmétriquement, dans lesquelles les blocs amovibles sont montés respectivement sur les côtés des couvercles des postes de traitement qui sont tournés radialement vers l'extérieur. On dispose ainsi d'un accès facile aux blocs amovibles depuis l'extérieur de l'installation.

L'invention sera mieux comprise à la lecture de la description détaillée qui suit de certains modes de réalisation préférés donnés uniquement à titre d'exemples purement illustratifs. Dans cette description, on se réfère aux dessins annexés sur lesquels :
- la figure 1 est une vue en perspective d'une partie d'un poste de traitement agencé avec un bloc amovible ;
- la figure 2 est une vue schématique en coupe, à échelle agrandie, montrant un agencement d'électrovanne dans le bloc amovible de la figure 1 ;
- la figure 3 est une vue schématique en coupe, à échelle agrandie, montrant une variante d'agencement d'électrovanne dans le bloc amovible de la figure 1 ;
- la figure 4 est une vue, en perspective et en partie éclatée, d'une partie d'une installation de traitement de récipients agencée, conformément à l'invention, avec un regroupement deux par deux des postes de traitement ;
- la figure 5 est une vue, en perspective et partiellement éclatée, analogue à celle de la figure 4 avec le bloc amovible détaché des deux postes de traitement ; et
- la figure 6 est une vue en perspective du bloc amovible avec sa face d'accouplement visible.

L'invention vise à perfectionner les installations agencées pour déposer, au moyen d'un plasma micro-ondes, un revêtement formant barrière sur la face interne de récipients en matière thermoplastique telle que du PET, une telle installation comprenant une multiplicité de postes de traitement de récipients.

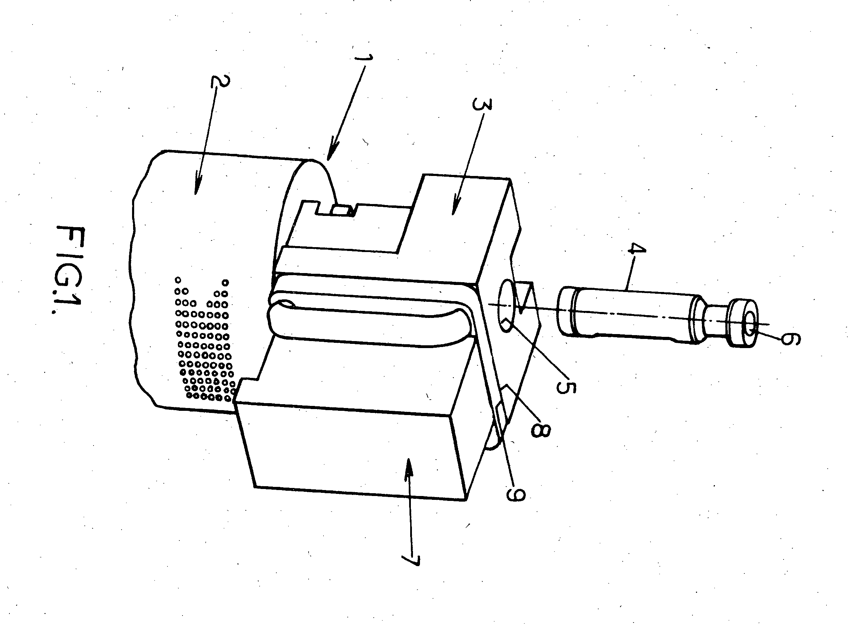

A la figure 1 est montré un unique poste de traitement désigné dans son ensemble par la référence numérique 1, et seule une partie, utile à la compréhension des perfectionnements apportés par l'invention, est représentée schématiquement en vue extérieure et en perspective.

Pour l'essentiel, chaque poste 1 de traitement comporte notamment :
- une enceinte 2 de traitement appropriée pour recevoir au moins un récipient à traiter et équipée pour que puisse y être développé le processus de dépôt, notamment sur sa face intérieure, d'un revêtement d'un matériau barrière (par exemple du carbone) au moyen d'un plasma micro-ondes à partir d'un gaz précurseur injecté dans l'enceinte, et
- un couvercle 3 surmontant l'enceinte 2 et incluant une chambre de pompage à vide (non visible sur la figure 1) dans laquelle des moyens de raccordement étanche avec le récipient comportent une chemise 4 de forme générale tubulaire coaxiale au col du récipient et qui, pour faciliter la compréhension, est, sur la figure 1, montrée sortie hors de son logement 5 du couvercle 3 ; le couvercle 3 supporte également un injecteur tubulaire (non montré) traversant coaxialement (passage 6) ladite chemise 4 et propre à injecter un fluide réactionnel dans le récipient lors du déroulement du processus de traitement dudit récipient pour la formation d'une couche de matériau barrière sur la face intérieure de celui-ci.

Une description plus détaillée d'un poste de traitement ainsi agencé peut-être trouvée dans le document FR 2 872 148 au nom de la Demanderesse.

Avec cette chambre de pompage à vide sont en communication des organes fonctionnels (non visibles sur la figure 1) de ladite installation qui sont susceptibles, lors du fonctionnement de l'installation, d'être recouverts au moins partiellement de matériau pulvérulent duquel le susdit revêtement est constitué.

On prévoit :
que les organes fonctionnels (non visibles sur la figure 1) soient regroupés dans un bloc 7 amovible qui est fixable sur le couvercle 3 de préférence à l'aide de moyens de fixation rapide et soient abrités dans des logements respectifs prévus dans une face 8 d'accouplement dudit bloc 7 amovible,
que le couvercle 3 incorpore les liaisons fonctionnelles qui sont nécessaires aux fonctionnements respectifs desdits organes fonctionnels et qui débouchent sur une face 9 d'accouplement dudit couvercle 3, lesdites faces 8, 9 d'accouplement respectivement du bloc 7 amovible et du couvercle 3 étant mutuellement conformées complémentairement, et
que les susdites liaisons et les susdits logements abritant les organes fonctionnels respectifs soient connectés respectivement lorsque ledit bloc 7 amovible est monté sur ledit couvercle 3 avec lesdites faces 8, 9 d'accouplement respectives coopérant mutuellement.

A la figure 1, le bloc 7 amovible est montré monté sur le couvercle 3.

Les organes fonctionnels visés par les aménagements proposés dans le contexte de l'invention sont les organes dont le fonctionnement est susceptible d'être perturbé, voire annihilé par la présence de matériau barrière pulvérulent. Sont concernés notamment les capteurs de pression et débitmètres mis en oeuvre pour le contrôle du fonctionnement du poste de traitement, mais aussi et surtout les électrovannes servant au contrôle de la mise sous vide de l'enceinte à partir d'une pompe à vide extérieure et à la mise à l'atmosphère, électrovannes dans lesquelles la présence de matériau pulvérulent sur les joints d'étanchéité des clapets affecte négativement la qualité de l'étanchéité d'obturation desdits clapets.

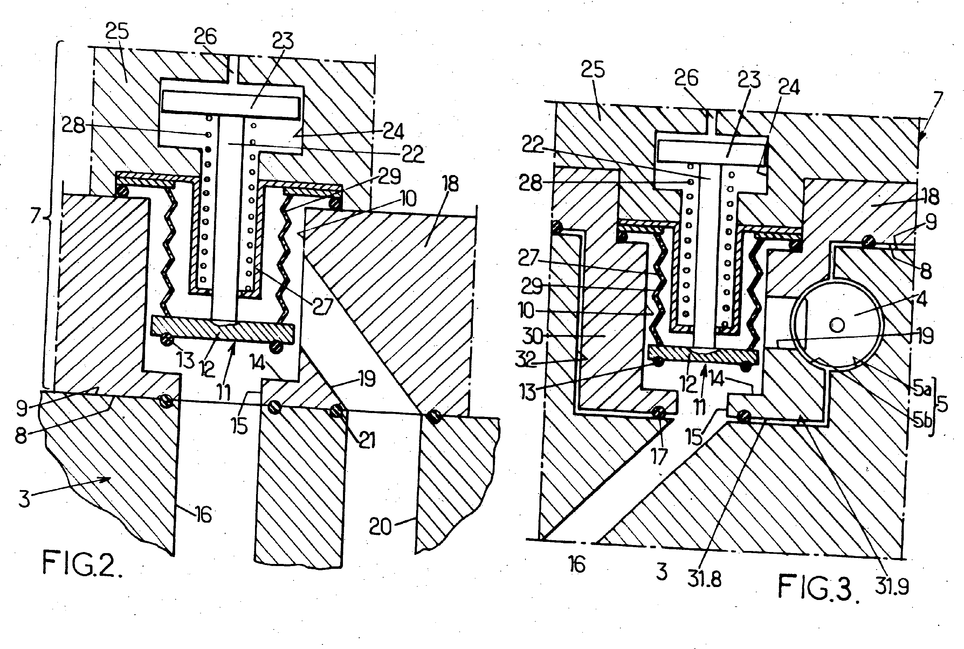

C'est plus précisément en relation avec organes fonctionnels constitués par des électrovannes que vont être maintenant exposés deux exemples concrets d'aménagement du bloc 7 amovible, en regard des deux figures 2 et 3 respectivement.

En se reportant tout d'abord à l'exemple de la figure 2, le bloc 7 amovible comporte un corps 18 dans lequel est prévu un logement, désigné dans son ensemble par la référence numérique 10, qui abrite tous les composants d'une électrovanne désignée par la référence numérique 11.

L'électrovanne 11 comprend un clapet 12 muni d'au moins un joint d'étanchéité 13 et propre à coopérer avec un épaulement 14 en vis-à-vis entourant un orifice 15 débouchant sur la face frontale du corps 18 constituant la susdite face 8 d'accouplement du bloc 7 amovible. Cette face 8 d'accouplement du bloc 7 amovible est conformée pour coopérer avec la face 9 d'accouplement en vis-à-vis du couvercle 3 sur laquelle débouche, sensiblement aligné coaxialement avec l'orifice 15 du bloc 7 amovible, un passage 16 pratiqué à travers le couvercle 3. Un joint 17 d'étanchéité est prévu entre les deux faces 8, 9 coopérantes ; il peut notamment être monté sur la face 8 coopérante du bloc 7 amovible, autour de l'orifice 15.

Dans le logement 10, par exemple sur la paroi latérale de celle-ci, débouche un conduit 19 percé dans le corps 18 du bloc 7 amovible et qui, à son extrémité opposé, débouche sur la face 8 d'accouplement du bloc 7 amovible en regard d'un passage 20 pratiqué dans le couvercle 3 et débouchant sur la face 9 d'accouplement de celui-ci, un joint 21 d'étanchéité, par exemple supporté par le bloc 7 amovible étant interposé entre les deux faces 8, 9 d'accouplement.

Le clapet 12 de l'électrovanne peut être entraîné par un vérin pneumatique. A cet effet, le clapet 12 est solidaire, par l'intermédiaire d'une tige 22, d'une tête 23 de piston mobile dans une chambre 24 pratiquée dans un corps 25 d'électrovanne fixé sur le corps 18 du bloc 7 amovible. Un conduit 26 d'amenée du fluide pneumatique de commande (air sous pression, typiquement sous 7x10⁵ Pa) débouche dans la chambre 24 pour commander le déplacement de la tête 23 du piston, et donc du clapet 12. Une douille 27 de guidage, qui s'étend dans le logement 10, d'une part sert à guider la tige 22 et d'autre part sert d'appui à une extrémité d'un ressort 28 de rappel entourant coaxialement la tige 22 et dont l'autre extrémité prend appui sous la tête 23 de piston pour rappeler l'équipage mobile formé par le clapet 12, la tige 22 et la tête 23 de piston en position de repos (correspondant dans l'exemple illustré à la position d'ouverture du clapet 12). Enfin, un dispositif d'étanchéité tel qu'un soufflet 29 est interposé de façon étanche entre le clapet 12 et le corps 25 de l'électrovanne.

Dans un but de simplification de l'entretien et de permettre un remplacement rapide de l'électrovanne en cas de nécessité, l'électrovanne 11 peut avantageusement être du type cartouche insérable dans un logement du corps 18 du bloc 7 amovible (non montré de façon détaillée).

Dans l'agencement qui vient d'être décrit en relation avec la figure 2, les faces 8 et 9 d'accouplement appartenant respectivement au bloc 7 amovible et au couvercle 3 sont sensiblement planes, tout au moins dans leurs zones respectives directement concernées par l'implantation de cette électrovanne.

A la figure 3 est illustré un autre exemple d'agencement dans lequel sont présents les mêmes composants. Par contre, d'une façon différente de ce qui a été exposé ci-dessus, le clapet 12 de l'électrovanne est abrité dans une partie 30 en saillie par rapport à la face 8 d'accouplement ; de son côté, le couvercle 3 comporte un évidement 32 propre à recevoir ladite partie 30 en saillie du bloc 7 amovible. C'est alors entre la face 31.8 frontale de la partie 30 en saillie et le fond 31.9 de l'évidement 32 qu'est interposé le joint 17 d'étanchéité. Un tel agencement, qui reste fonctionnellement équivalent au précédent, offre cependant l'avantage de simplifier l'implantation dans certains cas, notamment pour la communication destinée à l'établissement du vide à l'intérieur du récipient à traiter. Cette communication s'établit à travers la chemise 4 installée dans son logement 5 prévu à l'intérieur du couvercle 3. L'agencement proposé dans le cadre de cet aménagement permet de déporter le logement 10 abritant le clapet d'électrovanne approximativement en regard du logement 5 de la chemise 4. Ainsi, le conduit 19 précité peut déboucher directement dans ce logement 5. Dans l'exemple de réalisation intéressant montré à la figure 3, le logement 5 est défini en partie (5a) seulement dans le couvercle 3 et en partie (5b) dans la partie 30 en saillie ; le conduit 19 débouche directement dans ladite partie 5b. Dans cette configuration, le passage 16 est en liaison avec la source de vide, tandis que le conduit 19 est en liaison, via la chemise 4, avec le volume intérieur du récipient à traiter.

Ainsi, pour chaque poste de traitement le bloc 7 amovible comporte une électrovanne de mise sous vide du volume intérieur du récipient à traiter qui est installée selon l'agencement illustré à la figure 3 et trois autres électrovannes (mise sous vide de l'enceinte à l'extérieur du récipient, remise à la pression atmosphérique du volume intérieur du récipient, remise à la pression atmosphérique de l'enceinte à l'extérieur du récipient) qui sont installées selon l'agencement illustré à la figure 2.

Grâce à l'agencement proposé, lorsqu'au moins un joint d'électrovanne doit être nettoyé ou remplacé, le bloc 7 amovible concerné est enlevé et remplacé aussitôt par un bloc 7 amovible en bon état de fonctionnement tenu en réserve, ce qui permet de n'immobiliser l'installation qu'un temps très bref ; l'entretien sur le bloc enlevé se fait ensuite en dehors de la machine, en atelier, dans des conditions optimales et le bloc rénové est ensuite tenu en réserve.

De même, dans le contexte d'un entretien préventif systématique, tous les blocs 7 amovibles de l'installation peuvent être démontés et remplacés par des blocs préalablement rénovés et tenus en réserve ; le temps d'immobilisation de l'installation est alors réduit à un minimum, avec comme contrepartie la nécessité de disposer de deux jeux complets de blocs amovibles.

Comme cela a déjà été souligné plus haut, les dispositions conformes à l'invention trouvent un intérêt d'autant plus grand que l'installation est pourvue d'un nombre élevé de postes de traitement. Dans ce contexte, on peut encore envisager une amélioration de la réduction du temps d'immobilisation de l'installation aux fins de maintenance en prévoyant, conformément à l'invention, que les postes 1 de traitement soient répartis en groupes comprenant plusieurs postes adjacents, qu'un bloc 7 amovible commun regroupe les organes fonctionnels desdits plusieurs postes 1 adjacents d'un groupe de postes, et que ledit bloc 7 amovible commun soit fixable sur les faces 9 d'accouplement des couvercles 3 des postes respectifs.

Notamment alors, les enceintes 2 des postes 1 de traitement adjacents d'un groupe de postes sont rapprochées l'une de l'autre et juxtaposées et les couvercles 3 respectifs sont eux aussi juxtaposés. Dans ce cas, on peut encore pousser l'intégration des postes 1 de traitement d'un même groupe de postes plus loin en prévoyant que les couvercles respectifs des postes 1 de traitement d'un groupe de postes soient réunis sous forme d'un couvercle 3 unique commun.

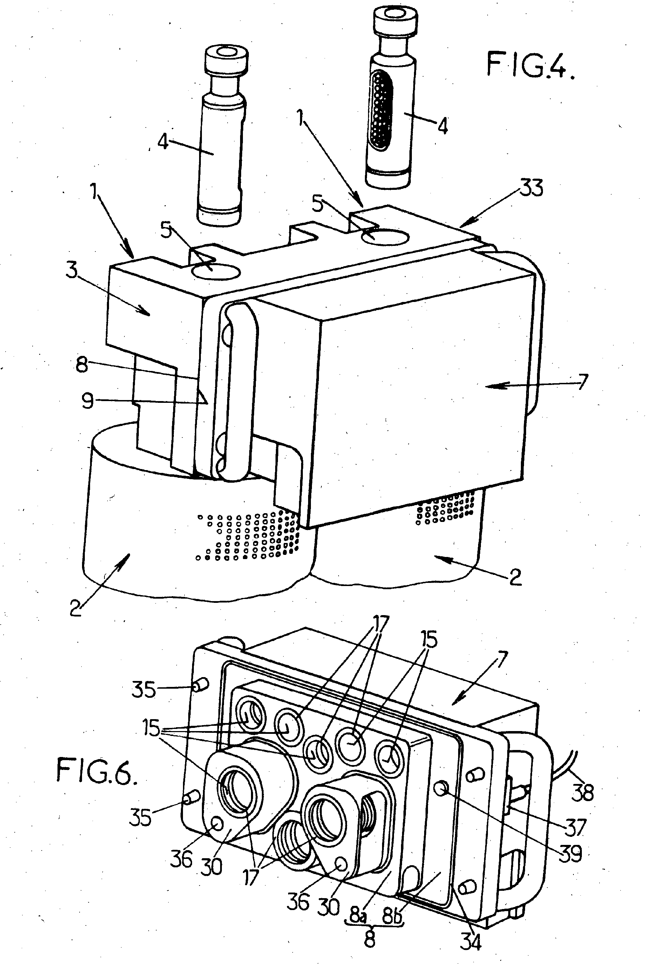

Les figures 4 à 6 des dessins annexés illustrent l'agencement précité dans le cas d'une installation équipée de postes de traitement en nombre pair. Les postes 1 de traitement sont alors disposés par groupes de deux désignés par la référence numérique 33, chaque groupe 33 de postes de traitement comprenant deux postes 1 de traitement adjacents.

Comme on le voit clairement sur la figure 4 qui est une vue en perspective, analogue à celle de la figure 1 montrant un poste unique, les deux enceintes 2 sont accolées l'une à l'autre et sont surmontées par un couvercle 3 commun qui regroupe les équipements respectifs nécessaires au fonctionnement des deux postes de traitement. De même qu'à la figure 1, les deux chemises 4 sont montrées sorties de leurs logements 5 respectifs. Le bloc 7 amovible commun regroupe les organes fonctionnels des deux postes 1 de traitement adjacents du groupe 33 de postes, et ledit bloc 7 amovible commun est fixable, de préférence par des moyens de fixation rapide, sur la face 9 d'accouplement du couvercle 3 commun.

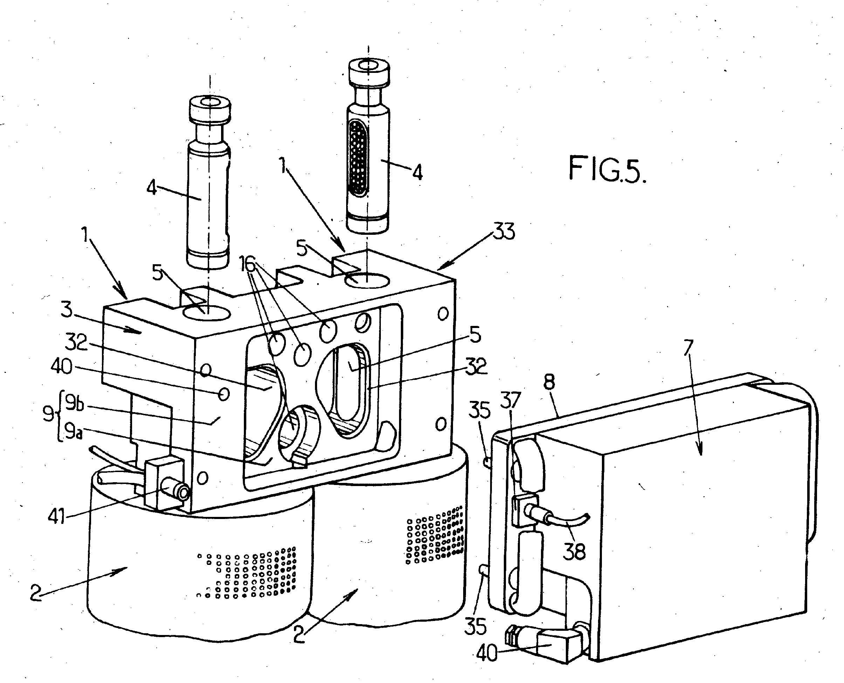

La figure 5 représente le groupe 33 de postes de traitement de la figure 4 dans lequel le bloc 7 amovible est démonté et écarté du couvercle 3, tandis qu'à la figure 6 le bloc 7 amovible est montré, en perspective, en position retournée avec sa face 8 d'accouplement visible.

Ces deux figures 5 et 6 permettent notamment d'identifier les deux agencements d'électrovanne de mise sous vide des volumes intérieurs des deux récipients traités par les deux postes 1 de traitement, avec notamment les parties 30 saillantes du bloc 7 amovible et les évidements 32 de formes complémentaires du couvercle 3 laissant apparaître en partie le logement 5 d'une chemise 4 (celle située sur la droite).

A la figure 6 apparaissent clairement les joints 17 assurant l'étanchéité individuelle de chaque orifice. On notera qu'une étanchéité complémentaire globale est procurée par un joint 34 entourant l'ensemble des orifices apparaissant sur la face 8 d'accouplement du bloc 7 commun.

Du fait du regroupement des électrovannes dans un bloc 7 amovible commun, on peut envisager que certaines d'entre elles puissent assurer une fonction commune pour les deux postes de traitement. Dans cette optique, on conserve une électrovanne de commande de mise sous vide du volume intérieur du récipient à traiter et une électrovanne de commande de remise à la pression atmosphérique du volume intérieur du récipient à traiter pour chaque poste de traitement, tandis qu'on peut prévoir une seule électrovanne de commande de mise sous vide du volume intérieur de l'enceinte à l'extérieur du récipient à traiter et une seule électrovanne de commande de remise à la pression atmosphérique du volume intérieur de l'enceinte à l'extérieur du récipient à traiter qui sont communes à tous les postes de traitement. Grâce à cette réduction du nombre des électrovannes, on réduit le coût des matériels utilisés ainsi que le coût de la maintenance des matériels conservés ; simultanément, on réduit sensiblement le volume du bloc 7 amovible commun, ce qui permet de diminuer l'encombrement et le poids de l'installation, ce qui conduit à une moindre inertie de celle-ci.

Dans un exemple concret de réalisation, il est intéressant que la face 8 d'accouplement du bloc 7 amovible soit constituée de façon étagée de manière à faciliter le guidage du bloc 7 amovible lors de son montage sur le couvercle 3 respectif et à faciliter la mise en place d'une étanchéité entre les faces coopérantes du bloc amovible et du couvercle. A cet effet, il est prévu que la partie 8a de la face d'accouplement qui regroupe les orifices 15 des logements d'électrovannes soit en saillie par rapport à une face 8b d'assemblage supportant des moyens 35 (visibles à la figure 6) de liaison mécanique avec le couvercle 3 ; de façon complémentaire, tels que des pions, la face 9 d'accouplement du couvercle 3 comporte un évidement 9a qui est propre à recevoir ladite partie 8a en saillie de la face 8 d'accouplement et qui est entouré par une face 9b d'assemblage propre à coopérer avec la face 8b d'assemblage du bloc 7 amovible. Le joint 34 précité est alors mis en place sur la face 8b d'assemblage comme montré à la figure 6.

On a également représenté, sur la figure 6, les deux logements abritant des capteurs 36 de vide qui débouchent sur les faces frontales des deux parties 30 saillantes respectives précitées abritant les électrovannes de mise sous vide destinées respectivement aux deux postes de traitement.

De même, sur les figures 5 et 6 est représenté un débitmètre 37, commun aux deux postes de traitement, destiné à la mesure du débit de gaz précurseur (acétylène par exemple) injecté dans les deux récipients à traiter. Le débitmètre 37, monté sur une face extérieure du bloc 7 amovible et raccordé à un conduit 38 d'alimentation en gaz précurseur, débouche par un canal 39 sur la face 8b du bloc 7 amovible ; un canal 40, percé en contrepartie dans le couvercle 3, communique avec les deux injecteurs (non représentés) disposés en partie haute au-dessus des chemises 4 et coaxiaux à celles-ci.

On soulignera que l'alimentation du bloc 7 amovible en énergie (électrique et pneumatique) peut se faire avantageusement au moyen de raccords automatiques, notamment au moyen d'un raccord combiné électrique-pneumatique comme illustré par le raccord 40 du bloc 7 amovible et le raccord 41 fixe du couvercle 3 sur la figure 5 (le raccord 40 n'est pas représenté sur la figure 6) .

Les dispositions conformes à l'invention peuvent trouver application dans des installations de conceptions diverses, et notamment de façon préférée, bien que non exclusivement, dans une installation dans laquelle, pour chaque poste 1 de traitement, le couvercle 3 est fixe et solidaire de l'enceinte 2 respective, et le fond de l'enceinte 2 est déplaçable axialement pour autoriser l'introduction et l'évacuation des récipients, disposés col en haut, par le fond de l'enceinte 2.

Par ailleurs, les dispositions conformes à l'invention sont tout particulièrement appropriées pour les installations à hautes performances à cadence élevées, équipées d'un nombre élevé de postes de traitement, telles que celles du type carrousel tournant et comportant un bâti rotatif supportant ladite multiplicité de postes 1 de traitement répartis périmétriquement, dans lesquelles les blocs 7 amovibles sont montés respectivement sur les côtés des couvercles 3 des postes de traitement qui sont tournés radialement vers l'extérieur. On dispose ainsi d'un accès facile et direct aux blocs amovibles depuis l'extérieur de l'installation sans qu'il soit nécessaire de contourner, ni de démonter d'autres organes, ce qui permet de réduire, là aussi, les temps d'intervention pour l'échange des blocs 7 amovibles.

L'invention est définie par les revendications.

## Revendications

1. Installation pour déposer, au moyen d'un plasma micro-ondes, un revêtement formant barrière sur la face interne de récipients en matière thermoplastique telle que du PET, cette installation comprenant des organes (11, 36, 37) fonctionnels susceptibles d'être recouverts au moins partiellement de matériau pulvérulent constitutif du susdit revêtement lors du fonctionnement de l'installation, une multiplicité de postes (1) de traitement de récipients qui comportent chacun une enceinte (2) de traitement et un couvercle (3) incluant une chambre de pompage à vide avec laquelle sont en communication lesdits organes (11, 36, 37) fonctionnels, un bloc (7) amovible fixable sur le susdit couvercle (3), lesdits organes (11, 36, 37) fonctionnels étant regroupés dans ledit bloc (7) et abrités dans des logements (10) respectifs prévus dans une face (8) d'accouplement dudit bloc (7) amovible, le susdit couvercle (3) incorporant les liaisons (16, 20) fonctionnelles qui sont nécessaires aux fonctionnements respectifs desdits organes (11, 36, 37) fonctionnels et qui débouchent sur une face (9) d'accouplement dudit couvercle (3), lesdites faces (8, 9) d'accouplement du bloc (7) amovible et du couvercle (3) étant mutuellement conformées complémentairement, et les susdites liaisons (16, 20) et les susdits logements (10) abritant les organes (11, 36, 37) fonctionnels respectifs qui sont connectés respectivement lorsque ledit bloc (7) amovible est monté sur ledit couvercle (3) avec leurs faces (8, 9) d'accouplement respectives coopérant mutuellement,
**caractérisée**
**en ce que** les postes (1) de traitement sont en nombre pair,
**en ce que** chaque groupe de traitement (33) de postes de traitement comprend deux postes (1) adjacents,
**en ce que** le bloc (7) amovible est commun à deux postes adjacents d'un groupe (33) de postes et est fixable sur les faces d'accouplement des couvercles (3) des deux postes (1) adjacents,
**en ce que** lesdits organes (11, 36, 37) fonctionnels desdits deux postes (1) adjacents d'un groupe (33) de postes sont regroupés dans ledit bloc (7) amovible commun.

2. Installation selon la revendication 1, **caractérisée en ce que** les susdits organes fonctionnels comprennent des électrovannes (11) de commande sélective d'établissement du vide et de la pression atmosphérique dans l'enceinte (2) et dans le récipient à traiter.

3. Installation selon l'une quelconque des revendications 1 à 2, **caractérisée en ce que** les susdits organes fonctionnels comprennent au moins un capteur (36) de vide et/ou au moins un débitmètre (37).

4. Installation selon la revendication 2, **caractérisée en ce que** les logements (10) des électrovannes (11) de commande du vide à l'intérieur du récipient sont disposés dans des parties (30) du bloc (7) amovible en saillie sur la face (8) d'accouplement et **en ce, que** la face (9) d'accouplement, du couvercle (3) comporte des évidements (32), de formes complémentaires, propres à recevoir lesdites parties (30) en saillie.

5. Installation selon l'une quelconque des revendications 1 à 4, **caractérisée en ce que** ladite face (8a) d'accouplement du bloc (7) amovible est en saillie par rapport à une face (8b) d'assemblage supportant des moyens (35) de liaison mécanique avec le couvercle(3) et **en ce que** le couvercle (3) comporte un évidement (9a) propre à recevoir ladite face (8a) d'accouplement en saillie.

6. Installation selon l'une quelconque des revendications 1 à 5, **caractérisée en ce que** les postes (1) de traitement sont répartis en groupes (33) comprenant plusieurs postes adjacents, **en ce qu'**un bloc (7) amovible commun regroupe les organes (11, 36, 37) fonctionnels desdits plusieurs postes (1) adjacents d'un groupe (33) de postes, et **en ce que** ledit bloc (7) amovible est fixable sur les faces (9) d'accouplement des couvercles (3) des postes (1) respectifs.

7. Installation selon la revendication 6, **caractérisée en ce que** les enceintes (2) des postes (1) de traitement adjacents d'un groupe (33) de postes sont rapprochées l'une de l'autre et juxtaposées et **en ce que** les couvercles (3) respectifs sont eux aussi juxtaposés.

8. Installation selon la revendication 7, **caractérisée en ce que** les postes (1) de traitement d'un groupe (33) de postes sont munis d'un couvercle (3) unique commun et **en ce que** ledit bloc (7) amovible est fixable sur la face (3) d'accouplement du couvercle (3) commun.

9. Installation selon la revendication 2 et l'une quelconque des revendications 6 à 8, dans laquelle à chaque poste (1) de travail sont fonctionnellement associées :
- une électrovanne de commande de mise sous vide du volume intérieur de l'enceinte (2) à l'extérieur du récipient à traiter,
- une électrovanne de commande de mise sous vide du volume intérieur du récipient à traiter,
- une électrovanne de commande de remise à la pression atmosphérique du volume intérieur de l'enceinte (2) à l'extérieur du récipient à traiter, et
- une électrovanne de commande de remise à la pression atmosphérique du volume intérieur du récipient à traiter,
**caractérisée**
**en ce qu'**elle comprend une électrovanne de commande de mise sous vide du volume intérieur du récipient à traiter et une électrovanne de commande de remise à la pression atmosphérique du volume intérieur du récipient à traiter pour chaque poste (1) de traitement et
**en ce qu'**elle comprend une seule électrovanne de commande de mise sous vide du volume intérieur de l'enceinte (2) à l'extérieur du récipient à traiter et une seule électrovanne de commande de remise à la pression atmosphérique du volume intérieur de l'enceinte (2) à l'extérieur du récipient à traiter qui sont communes à tous les postes (1) de traitement du groupe (33) de postes de traitement.

10. Installation selon l'une quelconque des revendications 1 à 9, caractérisée, pour chaque poste (1) de traitement,
en ce que le couvercle (3) est fixe et solidaire de l'enceinte (2) respective, et
en ce que le fond de l'enceinte (2) est déplaçable axialement pour autoriser l'introduction et l'évacuation des récipients, disposés col en haut, par le fond de l'enceinte (2).

11. Installation selon l'une quelconque des revendications 1 à 10, **caractérisée en ce qu'**elle est du type carrousel tournant et comporte un bâti rotatif supportant ladite multiplicité de postes (1) de traitement répartis périmétriquement, et **en ce que** les blocs (7) amovibles sont montés respectivement sur les côtés des couvercles (3) des postes de traitement qui sont tournés radialement vers l'extérieur.

## Patentansprüche

1. Vorrichtung zum Aufbringen einer Beschichtung mittels eines Mikrowellenplasmas, die auf der Innenseite von Behältern aus thermoplastischem Material, wie PET, eine Barriere bildet, umfassend Funktionsorgane (11, 36, 37), die im Betrieb der Vorrichtung zumindest teilweise von Pulvermaterial, welches die Beschichtung ausbildet, bedeckt werden können, eine Vielzahl von Stationen (1) zur Behälterbearbeitung, die jeweils einen Bearbeitungsraum (2) und eine Abdeckung (3) aufweisen, welche eine Vakuumpumpkammer einschließen, mit der die Funktionsorgane (11, 36, 37) in Kommunikation stehen, einen an der Abdeckung (3) befestigbaren, abnehmbaren Block (7), wobei die Funktionsorgane (11, 36, 37) im Block (7) gruppiert und in entsprechenden Aufnahmen (10) untergebracht sind, die auf einer Kopplungsseite (8) des abnehmbaren Blocks (7) vorgesehen sind, wobei die Abdeckung (3) Funktionsverbindungen (16, 20) beinhaltet, die für die jeweiligen Funktionen der Funktionsorgane (11, 36, 37) erforderlich sind und zu einer Kopplungsseite (9) der Abdeckung (3) führen, wobei die Kopplungsseiten (8, 9) des abnehmbaren Blocks (7) und der Abdeckung (3) einander ergänzend ausgeführt sind und wobei die Verbindungen (16, 20) und die Aufnahmen (10) die jeweiligen Funktionsorgane (11, 36, 37) aufnehmen, die jeweils angeschlossen sind, wenn der abnehmbare Block (7) an der Abdeckung (3) befestigt ist, wobei deren jeweilige Kopplungsseiten (8, 9) zusammenwirken,
**dadurch gekennzeichnet,**
**dass** die Bearbeitungsstationen (1) geradzahlig sind,
**dass** jede Bearbeitungsgruppe (33) von Bearbeitungsstationen zwei benachbarte Stationen (1) umfasst,
**dass** der abnehmbare Block (7) für zwei benachbarte Stationen einer Gruppe (33) von Stationen gemeinsam ist und an den Kopplungsseiten der Abdeckungen (3) der beiden benachbarten Stationen (1) befestigbar ist,
**dass** die Funktionsorgane (11, 36, 37) der beiden benachbarten Stationen (1) einer Gruppe (33) von Stationen im gemeinsamen abnehmbaren Block (7) gruppiert sind.

2. Vorrichtung nach Anspruch 1, **dadurch gekennzeichnet, dass** die Funktionsorgane Magnetventile (11) zur selektiven Steuerung der Evakuierung und der Erzeugung des atmosphärischen Drucks im Raum (2) und im zu behandelnden Behälter umfassen.

3. Vorrichtung nach einem der Ansprüche 1 bis 2, **dadurch gekennzeichnet, dass** die Funktionsorgane zumindest einen Vakuumsensor (36) und/oder zumindest einen Durchflussmesser (37) umfassen.

4. Vorrichtung nach Anspruch 2, **dadurch gekennzeichnet, dass** die Aufnahmen (10) der Magnetventile (11) zur Steuerung des Vakuums innerhalb des Behälters in Bereichen (30) des abnehmbaren Blocks (7) angeordnet sind, die auf der Kopplungsseite (8) hervorragen, und dass die Kopplungsseite (9) der Abdeckung (3) Aussparungen (32) komplementärer Formen aufweist, welche die hervorragenden Bereiche (30) aufnehmen können.

5. Vorrichtung nach einem der Ansprüche 1 bis 4, **dadurch gekennzeichnet, dass** die Kopplungsseite (8a) des abnehmbaren Blocks (7) in Bezug auf eine Montageseite (8b), die Mittel (35) zur mechanischen Verbindung mit der Abdeckung (3) trägt, hervorragt und dass die Abdeckung (3) eine Aussparung (9a) aufweist, welche die hervorragende Kopplungsseite (8a) aufnehmen kann.

6. Vorrichtung nach einem der Ansprüche 1 bis 5, **dadurch gekennzeichnet, dass** die Bearbeitungsstationen (1) in Gruppen (33) aufgeteilt sind, die mehrere benachbarte Stationen umfassen, und dass ein gemeinsamer abnehmbarer Block (7) die Funktionsorgane (11, 36, 37) der mehreren benachbarten Stationen (1) einer Gruppe (33) von Stationen gruppiert und dass der abnehmbare Block (7) an den Kopplungsseiten (9) der Abdeckungen (3) der jeweiligen Stationen (1) befestigbar ist.

7. Vorrichtung nach Anspruch 6, **dadurch gekennzeichnet, dass** die Räume (2) der benachbarten Bearbeitungsstationen (1) einer Gruppe (33) von Stationen aneinander angenähert sind und nebeneinanderliegen und dass die jeweiligen Abdeckungen (3) ihrerseits ebenfalls nebeneinanderliegen.

8. Vorrichtung nach Anspruch 7, **dadurch gekennzeichnet, dass** die Bearbeitungsstationen (1) einer Gruppe (33) von Stationen mit einer einzigen gemeinsamen Abdeckung (3) ausgestattet sind und dass der abnehmbare Block (7) an der Kopplungsseite (3) der gemeinsamen Abdeckung (3) befestigbar ist.

9. Vorrichtung nach Anspruch 2 und einem der Ansprüche 6 bis 8, wobei mit jeder Arbeitsstation (1) funktional verbunden sind:
- ein Magnetventil zur Steuerung der Evakuierung des Innenvolumens des Raums (2) außerhalb des zu behandelnden Behälters,
- ein Magnetventil zur Steuerung der Evakuierung des Innenvolumens des zu behandelnden Behälters,
- ein Magnetventil zur Steuerung der Wiederherstellung des atmosphärischen Drucks des Innenvolumens des Raums (2) außerhalb des zu behandelnden Behälters und
- ein Magnetventil zur Steuerung der Wiederherstellung des atmosphärischen Drucks des Innenvolumens des zu behandelnden Behälters,
**dadurch gekennzeichnet,**
**dass** sie für jede Bearbeitungsstation (1) ein Magnetventil zur Steuerung der Evakuierung des Innenvolumens des zu behandelnden Behälters und ein Magnetventil zur Steuerung der Wiederherstellung des atmosphärischen Drucks des Innenvolumens des zu behandelnden Behälters umfasst und
**dass** sie ein einziges Magnetventil zur Steuerung der Evakuierung des Innenvolumens des Raums (2) außerhalb des zu behandelnden Behälters und ein einziges Magnetventil zur Steuerung der Wiederherstellung des atmosphärischen Drucks des Innenvolumens des Raums (2) außerhalb des zu behandelnden Behälters umfasst, die für alle Bearbeitungsstationen (1) der Gruppe (33) von Bearbeitungsstationen gemeinsam sind.

10. Vorrichtung nach einem der Ansprüche 1 bis 9, für alle Bearbeitungsstationen (1) **dadurch gekennzeichnet,**
**dass** die Abdeckung (3) festsitzend und mit dem jeweiligen Raum (2) fest verbunden ist und
**dass** der Boden des Raums (2) axial bewegbar ist, um die Zu- und Abfuhr der aufrecht angeordneten Behälter über den Boden des Raums (2) zu ermöglichen.

11. Vorrichtung nach einem der Ansprüche 1 bis 10, **dadurch gekennzeichnet, dass** sie von der Art eines sich drehenden Karussells ist und ein drehbares Gehäuse aufweist, welches die Vielzahl an perimetrisch verteilten Bearbeitungsstationen (1) trägt, und dass die abnehmbaren Blöcke (7) jeweils an den Seiten der Abdeckungen (3) der Bearbeitungsstationen, die radial nach außen gedreht sind, befestigt sind.

## Claims

1. Installation for depositing, by means of a microwave plasma, a coating forming a barrier on the internal face of containers made of a thermoplastic, such as PET, this installation comprising functional components (11, 36, 37) liable to be covered, at least partially, with a powdery material constituting said coating during the operation of the installation, a multiplicity of stations (1) for the treatment of containers, each of which has a treatment chamber (2) and a cover (3) including a vacuum pumping chamber with which the functional components (11, 36, 37) are in communication, a detachable unit (7) that can be attached to said cover (3), said functional components (11, 36, 37) being grouped into the unit (7) and are sheltered inside respective housings (10) provided in a coupling face (8) of said detachable unit (7), said cover (3) incorporates functional connections (16, 20) that are necessary for the respective functioning of said functional components (11, 36, 37) and that open on a coupling face (9) of said cover (3), said coupling faces (8, 9) of the detachable unit (7) and of the cover (3) being mutually matched in a complementary manner, and said connections (16, 20) and said housings (10) sheltering the respective functional components (11, 36, 37) which are connected respectively when said detachable unit (7) is mounted on said cover (3) with their respective coupling faces (8, 9) mutually cooperating,
**characterized:**
**in that** the treatment stations (1) are in even numbers,
**in that** each treatment group (33) of treatment stations comprises two adjacent stations (1),
**in that** the detachable unit (7) is common to two adjacent stations of a group (33) of stations and is fixable on the coupling faces of the cover (3) of the two adjacent stations (1),
**in that** said functional components (11, 36, 37) of said two adjacent stations (1) of a group (33) of stations are grouped together in the common detachable unit (7).

2. Installation according to claim 1, **characterized in that** said functional components comprise solenoid valves (11) for selectively controlling the establishment of a vacuum and atmospheric pressure inside the chamber (2) and inside the container to be treated.

3. Installation according to any one of claims 1 to 2, **characterized in that** said functional components comprise at least one vacuum sensor (36) and/or at least one flow meter (37).

4. Installation according to claim 2, **characterized in that** the housings (10) of the solenoid valves (11) controlling the vacuum inside the container are positioned in portions (30) of the detachable unit (7) projecting on the coupling face (8) and **in that** the coupling face (9) of the cover (3) has recesses (32), with complementary shapes, able to receive said projecting portions (30).

5. Installation according to any one of claims 1 to 4, **characterized in that** said coupling face (8a) of the detachable unit (7) projects with respect to an assembling face (8b) supporting mechanical means of connection (35) with the cover (3), and **in that** the cover (3) has a recess (9a) capable of receiving said projecting coupling face (8a).

6. Installation according to any one of claims 1 to 5, **characterized in that** the treatment stations (1) are distributed in groups (33) comprising several adjacent stations, **in that** a common detachable unit (7) groups together the functional components (11, 36, 37) of said several adjacent stations (1) of a group (33) of stations, and **in that** said detachable unit (7) can be attached to the coupling faces (9) of the covers (3) of the respective stations (1).

7. Installation according to claim 6, **characterized in that** the chambers (2) of adjacent treatment stations (1) of a group (33) of stations are brought together and juxtaposed, and **in that** the respective covers (3) are also juxtaposed.

8. Installation according to claim 7, **characterized in that** the treatment stations (1) of a group (33) of stations are provided with a common single cover (3), and **in that** said detachable unit (7) can be attached to the coupling face (3) of the common cover (3).

9. Installation according to claim 2 and any one of claims 6 to 8, wherein the following are functionally associated with each work station (1):
- a solenoid valve for controlling the establishment of a vacuum in the internal volume of the chamber (2) outside the container to be treated,
- a solenoid valve for controlling the establishment of a vacuum in the internal volume of the container to be treated,
- a solenoid valve for controlling the re-establishment of atmospheric pressure inside the volume of the chamber (2) outside the container to be treated, and
- a solenoid valve for controlling the re-establishment of atmospheric pressure in the internal volume of the container to be treated,
**characterized in that**:
it comprises a solenoid valve for controlling the establishment of a vacuum in the internal volume of the container to be treated and a solenoid valve for controlling the re-establishment of atmospheric pressure in the internal volume of the container to be treated for each treatment station (1); and
it comprises a single solenoid valve for controlling the establishment of a vacuum in the internal volume of the chamber (2) outside the container to be treated and a single solenoid valve for controlling the re-establishment of atmospheric pressure in the internal volume of the chamber (2) outside the container to be treated that are common to all the treatment stations (1) of the group (33) of treatment stations.

10. Installation according to any one of claims 1 to 9, **characterized in that**, for each treatment station (1):
the cover (3) is fixed to and integral with the respective chamber (2), and
the bottom of the chamber (2) can be displaced axially in order to allow for the introduction and removal of containers, positioned with their necks uppermost, through the bottom of the chamber (2).

11. Installation according to any one of claims 1 to 10, **characterized in that** it is of the revolving carousel type and comprises a revolving frame supporting said multiplicity of treatment stations (1) distributed around the perimeter, and in which the detachable units (7) are mounted respectively on the sides of the covers (3) of the treatment stations that are turned radially outwards.
